Europäisches Patentamt

**European Patent Office**

**Office européen des brevets**

(19)

(11) Publication number: **0 198 604**
A1

(12)

# EUROPEAN PATENT APPLICATION

(21) Application number: **86301940.2**

(22) Date of filing: **17.03.86**

(51) Int. Cl.⁴: **C 23 C 16/50**
// H01J37/32, C23C16/54

(30) Priority: **18.03.85 US 713354**

(43) Date of publication of application: **22.10.86**
**Bulletin 86/43**

(84) Designated Contracting States: **CH DE FR GB IT LI NL**

(71) Applicant: **SOVONICS SOLAR SYSTEMS, 6180 Cochran Road, Solon Ohio 44139 (US)**

(72) Inventor: **Doehler, Joachim, 6183 Venice Drive, Union Lake Michigan 48084 (US)**
Inventor: **Izu, Masatsugu, 265 Manor Road, Birmingham Michigan 48008 (US)**

(74) Representative: **Jackson, Peter Arthur et al, GILL JENNINGS & EVERY 53-64 Chancery Lane, London WC2A 1HN (GB)**

(54) **Glow discharge deposition apparatus having confined plasma region.**

(57) Apparatus for confining an ionized plasma developed during glow discharge deposition of thin film semiconductor alloy material to a preselected plasma region to deposit homogeneous semiconductor alloy material and to prevent etching of previously deposited semiconductor material. The apparatus (26) includes elongated plates (7a) disposed at ends of a cathode (34) in a deposition chamber (32). The plates are negatively biased during the deposition process to repel electrons in and thereby confine the plasma.

SOVONICS SOLAR SYSTEMS                    Ref: 50/2881/02

## GLOW DISCHARGE DEPOSITION APPARATUS
## HAVING CONFINED PLASMA REGION

This invention relates to an apparatus for continuously producing semiconductor devices on a substrate by depositing successive layers of semiconductor alloy material in a plurality of interconnected glow discharge deposition chambers. In the glow discharge deposition of semiconductor alloy material onto a substrate in such an apparatus, a mixture of precursor gases is introduced into each of the deposition chambers and directed to flow between a large area cathode plate and the electrically conductive, large area substrate spaced from the cathode. It is in this region, bounded by the cathode and substrate, referred to hereinafter as the plasma region, that a.c. or d.c. energy coupled to the cathode, develops an electromagnetic field that disassociates the mixture of precursor gases into activated species that result in deposition on the substrate. If the electromagnetic field is not uniform over the entire length and width of the cathode, the semiconductor alloy material deposited is not homogeneous. The difficult task of producing and maintaining uniform fields in a large deposition apparatus is made more difficult when higher intensity fields are employed. Applicant has recently determined that such high fields are desirable to deposit improved amorphous materials.

In the invention the problem of establishing and maintaining a uniform, high intensity electromagnetic field is solved by the addition to the deposition apparatus of confinement means that confine the plasma to a preselected portion of the plasma region. As a result, semiconductor alloy material is deposited on the substrate from only a preselected portion of the plasma region. In one preferred embodiment, the confinement means includes a pair of spaced elongated members that are electrically biased during the deposition process. One of the elongated members is disposed adjacent each of the opposed distal ends of the plasma region to confine the plasma to the central portion of that region. In another preferred embodiment, the confining members are part of shields that define the longitudinal extent of the plasma region. The members are biased with a direct current voltage to quench the plasma by repelling electrons toward the central portion of the plasma region. The biased members may be covered with insulating and conductive coatings to isolate them electrically from the rest of the deposition assembly, yet permit electrical biasing. In apparatus for the continuous deposition of semiconductor alloy material on an elongated web of substrate material, the confining members are preferably disposed adjacent the leading and trailing edges of the cathode.

Figure 1 is a fragmentary, cross-sectional view of a tandem photovoltaic device comprising a plurality of n-i-p type cells.

Figure 2 is a diagrammatic representation of a multiple discharge chamber glow deposition apparatus for continuous production of photovoltaic devices such as the cells shown in Figure 1.

Figure 3 is an enlarged, schematic representation of one embodiment of a plasma confining apparatus according to the invention.

Figure 4 is an enlarged, fragmentary perspective view, partially in cross-section, illustrating a second embodiment of a plasma confining apparatus according to the invention.

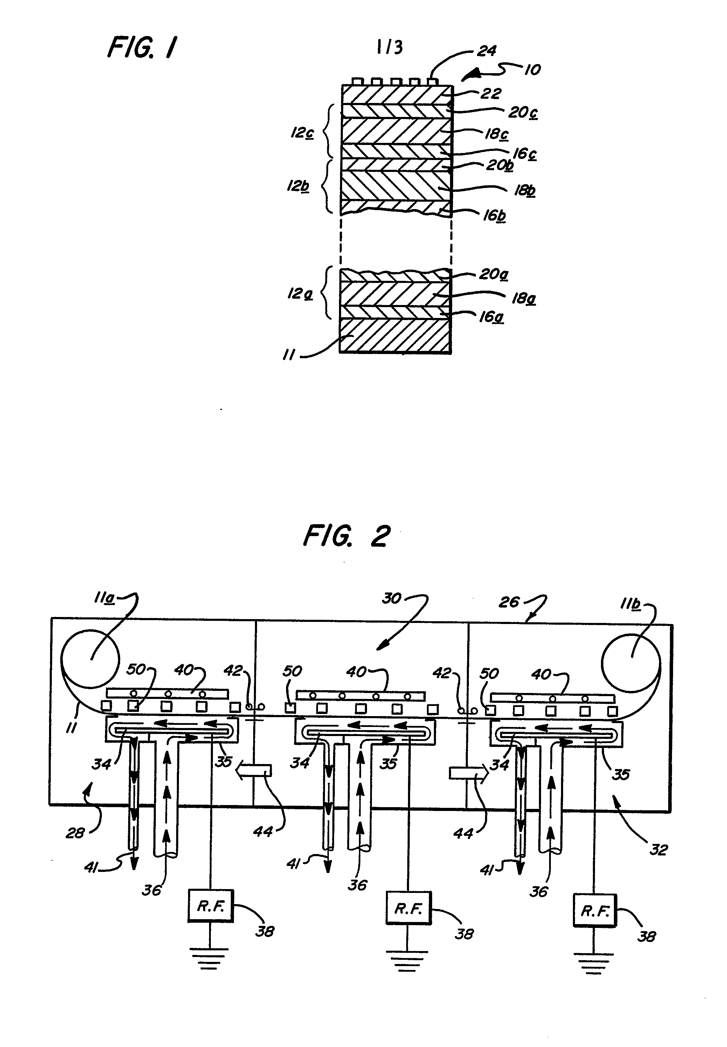

Figure 1 shows a n-i-p type photovoltaic device, such as a solar cell, fabricated from a plurality of stacked, individual p-i-n type cells, such as cells 12a, 12b and 12c. Below the lowermost cell 12a is a substrate 11 which may be transparent, such as a glass or plastic, or formed from a metallic material such as stainless steel, aluminum, tantalum, molybdenum or chrome. Although certain applications may require a thin oxide layer and/or a series of base contacts prior to the application of the substantially amorphous semiconductor alloy material, for purposes of this application, the term "substrate" shall include not only a flexible film, but also any elements added thereto by preliminary processing.

3

Each of the cells 12a, 12b and 12c is fabricated with a substantially amorphous alloy body containing at least a silicon alloy. Each of the alloy bodies includes a p-type conductivity region or layer 20a, 20b and 20c; an intrinsic region or layer 18a, 18b and 18c; and a n-type conductivity region or layer 16a, 16b and 16c. As illustrated, cell 12b is an intermediate cell and, as indicated in Figure 1, additional intermediate cells may be stacked on the illustrated cells without departing from the spirit or scope of the present invention. Also, although n-i-p cells are illustrated, the plasma confinement apparatus of the invention may also be used with apparatus producing single or multiple p-i-n cells.

A TCO (transparent conductive oxide) layer 22, such as indium tin oxide, is deposited on the exposed layer of semiconductor alloy material of the uppermost cell. An electrode grid 24 may be added to increase the current collection efficiency of device 10.

In Figure 2, a multiple chamber glow discharge deposition apparatus 26 for the continuous production of semiconductor devices is illustrated including a triad of isolated, dedicated, glow discharge deposition chambers, 28, 30, 32, interconnected by a gas gate 42 through which sweep gases and a web of substrate material 11 may pass.

A layer of intrinsic semiconductor alloy material is deposited in chamber 30 on top of a doped layer deposited in chamber 28. Oppositely doped layers are deposited in chambers 28 and 32, respectively. In chamber 28, the layer is deposited directly on a web substrate 11. In chamber 32, the layer is deposited on the two previously deposited layers. Chambers may be added to or removed from the apparatus to produce semiconductor devices having different structures.

Within each deposition chamber is a cathode plate 34, a gas confinement shield (a cathode shield) 35 disposed about cathode 34, a process gas supply conduit 36, an evacuation conduit 41, a plurality of transversely extending magnetic elements 50, and a plurality of radiant heating elements 40, shown schematically in Figure 2. A gas gate 42 interconnects the adjacent deposition chambers. A flow of gas is provided to the gas gates to prevent the dopant gases in chambers 28 and 32 from entering chamber 30. An electrical power source 38 is connected to each of the cathodes. The electrical power may be direct current or alternating current at radio frequencies or higher. Supply conduits 36 and cathode plates 34 deliver process gas mixtures to the plasma region in each deposition chamber between cathode 34 and a substrate web 11. Cathode shield 35 operates in conjunction with substrate web 11 and evacuation conduit 41 to confine the mixture of process gases to the vicinity of the cathode.

During deposition processing, generators 38, cathode plate 34, radiant heaters 40 and electrically grounded web 11 cooperate to form the plasma by disassociating gases in the plasma region. Magnetic web 11 is maintained substantially flat by the plurality of rows of magnetic elements 50.

To deposit layers of semiconductor alloy material that are uniform and homogeneous across the entire area of web material 11, the precursor process gases must have been subjected to a uniform electromagnetic field for substantially identical lengths of time. When relatively high power density electromagnetic fields are used in deposition processes, the energetic plasma that is generated extends into narrow spaces within the deposition apparatus. These spaces are not invaded by lower power plasmas. Such high energy plasmas have been found particularly useful in depositing microcrystalline, p-type fluorinated amorphous silicon layers. The intruding high energy plasma can result in the rapid etching of previously deposited semiconductor alloy material before the next layer is deposited and the etching of a freshly deposited layer as the substrate passes out of a chamber.

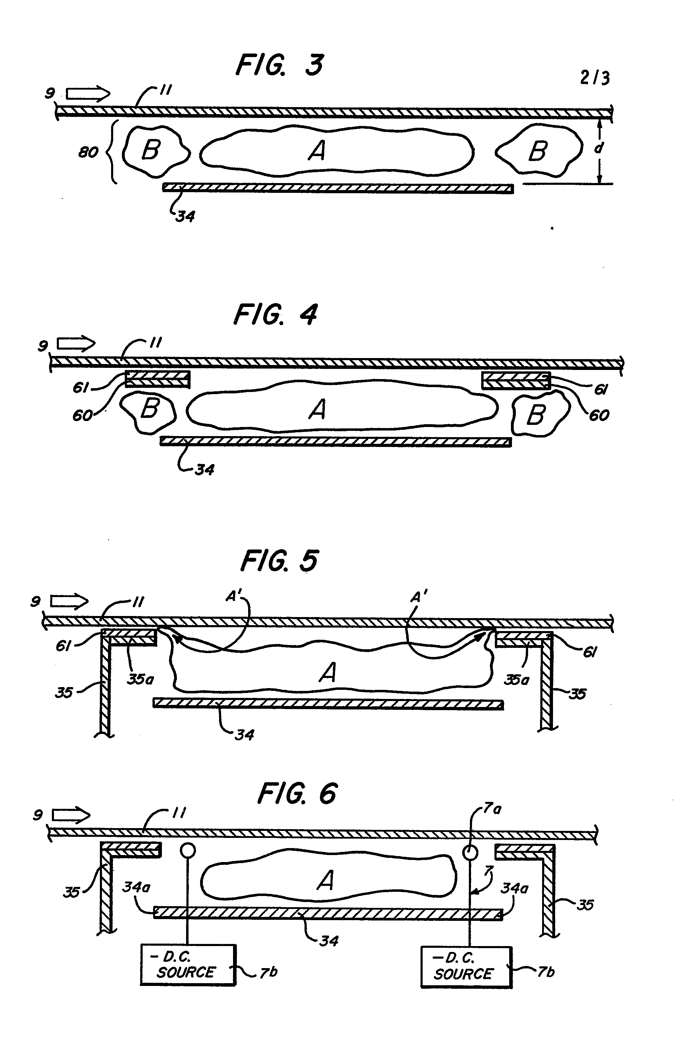

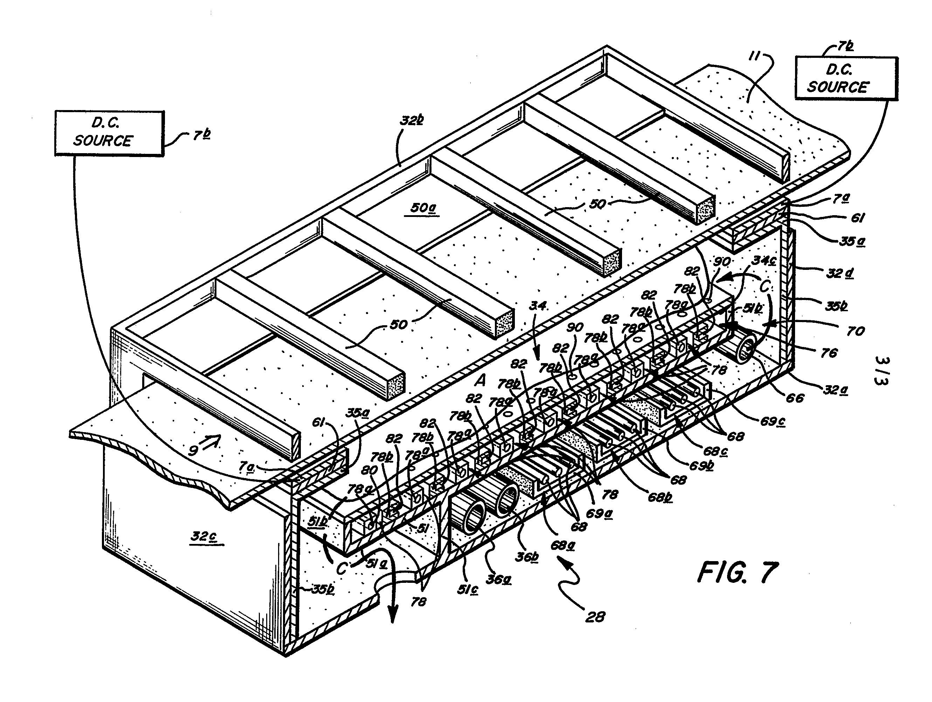

In Figure 3, substrate web 11 moves through a deposition chamber in the direction indicated by arrow 9. An elongated member such as tube 7a is disposed adjacent each of the opposed distal ends of the central plasma region A (i.e., adjacent to the leading edge and the trailing edge of cathode plate 34 between cathode plate 34 and substrate 11). Each of members 7a is charged by a negative d.c. bias to a voltage of about 200 volts by a power source 7b. Each member 7a is substantially as long as the width of cathode plate 34. Negatively biased members 7a not only quench (i.e., repel electrons) the plasma to confine it to region A, but also inject electrons into the process gas mixture to help ignite and sustain the plasma.

A more detailed depiction of a glow discharge cathode assembly 70 including an embodiment of the invention is illustrated in Figure 4. Cathode assembly 70 includes means for introducing an additional gaseous precursor material from introductory manifold assemblies 78 into any specific, localized area of the plasma region. Such a cathode assembly is described in Canadian patent application 491,232 filed September 20, 1985, in European patent application 85306734.6 filed September 23, 1985 and in Japanese patent application 23853785 filed October 24, 1985. Arrow C indicates the direction of flow of process gases and arrow 9 indicates the direction of travel of web substrate 11.

In Figure 4, deposition chamber 32 is generally a rectangularly-shaped, box-like member including a bottom wall 32a, a top wall 32b, side walls 32c and 32d, and a back wall not shown. Cathode assembly 70 is disposed within deposition chamber 32 approximately midway between upper wall 32b and lower wall 32a. Cathode assembly 70 includes cathode plate 34 for receiving radio frequency power from power source 38 to generate a plasma in the precursor gases between cathode plate 34 and web 11. Web 11 enters chamber 32 from a downstream substrate entry port and exits from the chamber through an upstream substrate exit port. Web 11 travels close to the generally horizontally disposed shoulders 35a of shields 35 at the upper extent of their generally vertically disposed legs 35b. Vertical legs 35b are securely fastened to side walls 32c and 32d.

6

A supply manifold 36a introduces the primary semiconductor precursors into chamber 32 and a secondary supply manifold 36b introduces a secondary gaseous precursor. Supply manifolds 36a and 36b are both elongated, transversely extending, tubular members having apertures spaced along their lengths to introduce the respective primary and secondary precursor gases into the deposition chamber uniformly across the width of web 11.

A gas directing shield 51 extending across the width of chamber 32 has a generally horizontally disposed base support member 51a and longitudinally spaced, generally vertically disposed and upwardly extending cathode supporting legs 51b. The junction formed between the upright legs 51b of the shield 51 and the bottom surface 34c of the cathode plate 34 is free of leaks. This leak-free junction insures that all gaseous precursor materials introduced into a compartment 76 formed between cathode plate 34 and base support member 51a of shield 51 are introduced into the plasma region only through apertures 90 formed through cathode plate 34. Shield 51 further includes a generally vertically oriented leg 51c supporting horizontal support member 51a above the surface of bottom wall 32a and dividing the bottom portion of chamber 32 into gas introductory and gas exhaust segments. Vertical leg 51c is generally coextensive with the width of cathode plate 34 to isolate gaseous precursor materials in the plasma region from the exhaust of spent gaseous precursors from the plasma region.

A "precathode" assembly, such as electrically-conductive rod 66, may be disposed downstream of manifolds 36a and 36b. Precathode rod 66 begins the initial disassociation and recombination of gaseous precursor material flowing past it. It also collects impurities from the gaseous precursor material and contaminants from the walls of deposition chamber 32 as described in U.S. Patent 4,479,455. Each of banks 68a-68c of heating elements 68 includes a heat reflective shield 69a-69c, respectively, to direct heat to cathode assembly 70 to heat the precursor gases to a predetermined temperature. Another array of heating elements 40, schematically depicted in Figure 2, may be used to warm web 11 to a predetermined deposition temperature.

A plurality of manifold assemblies 78 disposed within compartment 76 includes adjacent gas receiving manifolds 78a and gas delivery manifolds 78b interconnected by a relatively small diameter capillary tube. Manifolds 78a and 78b are generally rectangularly shaped members extending transversely across the entire width of cathode plate 34. Each gas receiving manifold 78a includes a central bore 80 extending along its entire longitudinal length. Each gas delivery manifold 78b includes generally rectangularly shaped slots 82 with an open front face to feed additional gaseous precursor materials into compartment 76. These front faces are preferably disposed to direct emanating gaseous precursors in a sideward direction initially for introduction of the gas only into local areas of the plasma region.

To accommodate plasma confining apparatus 7 in the existing structure of chamber 32, confinement apparatus 7 preferably is part of horizontal shoulders 35a of shield 35 at the opposed distal ends (the leading and the trailing end) of cathode plate 34. Preferably, elongated, horizontally disposed plates 35a have their upper surfaces (i.e. the surfaces facing away from web 11) coated with a layer of an electrically insulating material 61 such as a polyimide like kapton (a trademark of E.I. DuPont de Nemous). An electrically conductive biasing member 7a is affixed on insulator 61. Each of plates 35a is coupled to a source of negative direct voltage for biasing members 7a.

8

## CLAIMS

1. A glow discharge deposition apparatus (26) for depositing layers of semiconductor alloy material on a substrate (11), the deposition apparatus comprising a deposition chamber (32) containing an elongated cathode (34) having opposed leading and trailing edges, and having entrance and exit ports for passing a web substrate (11) through said chamber spaced from said cathode (34) to define a plasma region (A) between said substrate and cathode, characterized in that means (7) for substantially confining the plasma to a preselected portion of the plasma region are disposed in said chamber.

2. The apparatus of claim 1 characterized in that said plasma confinement means comprises an electrically energizable member (7a) disposed proximate each of said leading and trailing edges of said cathode.

3. The apparatus of claim 2 characterized in that each energizable member is elongated and extends along substantially the entire width of the proximate edge of the cathode.

4. The apparatus of claim 2 characterized in that each of said energizable members comprises a plate (7a) mounted to and electrically insulated from said chamber.

5. The apparatus of claim 4 characterized in that each of said plates includes a layer of electrically insulating material (61) and a contigious electrically conducting layer.

6. The apparatus of claim 2 characterized in that each of said energizable members is disposed between said substrate and one of said leading and trailing edges of said cathode.

FIG. 1

FIG. 2

## FIG. 3

9

11

80 { B    A    B    d

34

## FIG. 4

9

11

61    61
60    60
B    A    B

34

## FIG. 5

9

11    A'    A'

61    61
35a    35a
35    A    35

34

## FIG. 6

9

11    7a

35    7
34a    34a    35
A
34

-D.C. SOURCE    7b    -D.C. SOURCE    7b

D.C. SOURCE

D.C. SOURCE

FIG. 7

European Patent Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 060 651 (ATLANTIC RICHFIELD) * page 13, lines 20-24; page 18, lines 26-30; page 20, lines 3-7 * | 1 | C 23 C 16/50 H 01 J 37/32 C 23 C 16/54 |
| | --- | | |
| X | EP-A-0 109 148 (ENERGY CONVERSION DEVICES) * Page 13, lines 1,2 * | 1 | |
| | --- | | |
| A | EP-A-0 002 383 (PLASMA PHYSICS) | | |
| | --- | | |
| A | EP-A-0 034 706 (VEB ZENTRUM) * Page 4, line 24 * | | |
| | --- | | TECHNICAL FIELDS SEARCHED (Int. Cl.4) |
| A | IBM TECHNICAL DISCLOSURE BULLETIN, vol. 21, no. 9, February 1979, page 3760; M. CHEN et al.: "Use of a magnetic field to adjust the stoichiometry of plasma-deposited thin films" | | C 23 C 16/00 H 01 J 37/00 |
| | --- | | |
| A | FR-A-2 518 581 (BAR & STROUD) * Page 3, line 33 * | | |
| | ----- | | |

The present search report has been drawn up for all claims

| Place of search | Date of completion of the search | Examiner |
|---|---|---|
| THE HAGUE | 04-07-1986 | DEVISME F.R. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82